(19) Europäisches Patentamt
European Patent Office
Office européen des brevets

(11) EP 3 275 570 A1

(12) **EUROPEAN PATENT APPLICATION**
published in accordance with Art. 153(4) EPC

(43) Date of publication:
**31.01.2018 Bulletin 2018/05**

(21) Application number: **15886410.8**

(22) Date of filing: **26.03.2015**

(51) Int Cl.:
***B22F 1/00*** (2006.01)   ***C09C 1/62*** (2006.01)
***C09D 5/24*** (2006.01)   ***C09D 201/00*** (2006.01)
***C25C 5/02*** (2006.01)   ***H01B 1/00*** (2006.01)
***H01B 1/22*** (2006.01)   ***H01B 5/00*** (2006.01)

(86) International application number:
**PCT/JP2015/059481**

(87) International publication number:
**WO 2016/151858 (29.09.2016 Gazette 2016/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Sumitomo Metal Mining Co., Ltd.**
**Tokyo 105-8716 (JP)**

(72) Inventors:
• **OKADA, Hiroshi**
  **Niihama-shi**
  **Ehime 792-0002 (JP)**
• **YAMASHITA, Yu**
  **Niihama-shi**
  **Ehime 792-0002 (JP)**

(74) Representative: **Jones, Nicholas Andrew**
**Withers & Rogers LLP**
**4 More London Riverside**
**London, SE1 2AU (GB)**

(54) **COPPER POWDER AND COPPER PASTE, CONDUCTIVE COATING MATERIAL, AND CONDUCTIVE SHEET USING SAME**

(57)     Provided is a copper powder that has an increased number of points of contact between copper powder particles, that ensures excellent conductivity, and that can be suitably used in a conductive paste, an electromagnetic wave shield, or the like. The copper powder is configured from flat plate-shaped copper particles 1 that form a dendritic shape having a linearly grown main trunk and a plurality of branches branching from the main trunk. The main trunk and the branches have an average cross-sectional thickness of more than 1.0 μm but no more than 5.0 μm. The copper powder has a flat plate shape that is configured from a layered structure of one layer or a plurality of stacked layers. The average particle size (D50) is 1.0-100 μm.

FIG. 1

**Description**

TECHNICAL FIELD

The present invention relates to a copper powder to be used as a material for an electrically conductive paste and the like, and more particularly, to a copper powder having a novel shape capable of improving electric conductivity and a copper paste using the same, an electrically conductive coating material, and an electrically conductive sheet.

BACKGROUND ART

A paste such as a resin type paste or a calcined type paste using a metal filler such as a silver powder or a copper powder is frequently used in the formation of a wiring layer, an electrode, and the like in an electronic device. A metal filler paste composed of silver powder or copper powder is applied or printed on various kinds of substrates of an electronic device and subjected to a treatment of heat curing or heat calcination to form an electrically conductive film to be a wiring layer or an electrode.

For example, a resin type electrically conductive paste is composed of a metal filler, a resin, a curing agent, a solvent, and the like, and it is formed into an electrically conductive film by being printed on an electric conductor circuit pattern or a terminal and cured by heating at from 100°C to 200°C so as to form a wire and an electrode. In a resin type electrically conductive paste, the thermosetting resin is cured and shrunk by heat, and metal fillers are thus joined by pressure and brought into contact with one another so that the metal fillers overlap each other, and as a result, an electrically connected current path is formed. This resin type electrically conductive paste is treated at a curing temperature of 200°C or lower so that it is often used in a substrate using a material susceptible to heat such as a printed wiring board.

In addition, a calcination type electrically conductive paste is composed of a metal filler, glass, a solvent, and the like, and it is formed into an electrically conductive film by being printed on an electric conductor circuit pattern or a terminal and calcined by heating at from 600°C to 800°C so as to form a wire and an electrode. The calcination type electrically conductive paste is treated at a high temperature so that electrical continuity is secured as the metal fillers are sintered together. This calcination type electrically conductive paste cannot be used in a printed wiring board using a resin material since the calcination temperature is high, but it is possible to realize low resistance since the metal fillers are sintered by being treated at a high temperature. Hence, the calcination type electrically conductive paste is used in an external electrode of a multilayer ceramic capacitor or the like.

Meanwhile, a silver powder has been so far used as a metal filler to be used in these resin type electrically conductive paste and calcination type electrically conductive paste. However, in recent years, the price of precious metals has soared and the use of a copper powder that is less expensive than the silver powder has been preferred for cost reduction.

Here, shapes such as a granular shape, a dendritic shape, and a flat plate shape have been used as the powder of copper or the like to be used as a metal filler since electricity is conducted as the particles are connected to one another. Particularly, in the case of evaluating the particles by the sizes in three directions, longitudinal, lateral, and thickness, a flat plate shape having a thin thickness has an advantage that it is possible to secure a larger contact area in which the particles are in contact with one another than cubic or spherical particles having a certain thickness so that low resistance, namely, high electric conductivity can be accordingly achieved as well as the flat plate shape contributes to thinning of the wiring material due to a decrease in thickness. Hence, a copper powder having a flat plate shape is particularly suitable for an application of an electrically conductive coating material or an electrically conductive paste for which electric conductivity is desired to be maintained. Incidentally, it is preferable to take the influence of impurities contained in the copper powder into consideration in the case of thinly applying the electrically conductive paste for use.

In order to fabricate such a flat plate-shaped copper powder, for example, a method for obtaining a flake-shaped copper powder suitable for a metal filler of an electrically conductive paste is disclosed in Patent Document 1. Specifically, a spherical copper powder having an average particle diameter of from 0.5 $\mu$m to 10 $\mu$m as a raw material is mechanically processed into a flat plate-shaped copper powder by mechanical energy of the medium loaded in the mill by using a ball mill or a vibration mill.

In addition, for example, a technique related to a copper powder for electrically conductive paste, in particular, a discoid copper powder capable of obtaining high performance as a copper paste for a through hole and an external electrode and a method for producing the same are disclosed in Patent Document 2. Specifically, a granular atomized copper powder is put in a medium stirring mill, from 0.5 weight% to 1 weight% fatty acid is added thereto with respect to the copper powder, and the copper powder is ground in the air or an inert atmosphere by using a steel ball having a diameter of from 1/8 inch to 1/4 inch as a grinding medium so as to be processed into a flat plate shape.

Furthermore, for example, a method for obtaining an electrolytic copper powder of which the moldability is improved as compared to an electrolytic copper powder of the prior art without developing the dendrite of the electrolytic copper powder more than necessary so that it can be molded to have high strength is disclosed in Patent Document 3.

Specifically, one kind or two or more kinds selected from a tungstate, a molybdate, and a sulfur-containing organic compound are added to an aqueous solution of copper sulfate of an electrolytic solution to precipitate an electrolytic copper powder for the purpose of miniaturizing the size of the crystallites constituting the electrolytic copper powder so as to precipitate an electrolytic copper powder which can be molded to have high strength through an increase in strength of the electrolytic copper powder itself.

In any of the methods disclosed in these Patent Documents, the granular copper powder obtained is formed into a flat plate shape by being mechanically deformed (processed) by using a medium such as a ball. Accordingly, the size of the flat plate-shaped copper powder formed through the processing is from 1 $\mu$m to 30 $\mu$m as an average particle diameter in the technique of Patent Document 1 and from 7 $\mu$m to 12 $\mu$m as an average particle diameter in the technique of Patent Document 3.

Meanwhile, an electrolytic copper powder precipitated in a dendritic shape called a dendritic shape is known, and such a dendritic electrolytic copper powder has a dendritic shape, and thus it has a large surface area, exhibits excellent moldability and sinterability, and is used as a raw material for an oil-retaining bearing, a mechanical part, or the like as a powder metallurgy application. In particular, the miniaturization of an oil-retaining bearing and the like has progressed, and the oil-retaining bearing and the like are required to be porous, thinned, and complicatedly shaped along with this. In order to meet these requirements, for example, a copper powder for metal powder injection molding which has a complicated three-dimensional shape and a high dimensional accuracy and a method for manufacturing an injection molded article using the same are disclosed in Patent Document 4. Specifically, it has been indicated that the copper powder can be molded to have a high strength since the dendrites of the adjacent electrolytic copper powders are intertwined with one another at the time of the compression molding so as to be firmly connected to one another by further developing the dendritic shape. Furthermore, it is described that it is possible to utilize the fact that a larger number of contact points are formed as compared to a spherical shape since the copper powder has a dendritic shape in the case of being utilized as a metal filler of an electrically conductive paste or an electromagnetic wave shield.

However, in the case of utilizing a dendritic copper powder as described above as a metal filler of an electrically conductive paste, an electromagnetic wave shielding resin, or the like, the dendritic copper powders are intertwined with one another to cause aggregation when the metal filler in the resin has a dendritically developed shape, and thus a problem that the dendritic copper powders are not uniformly dispersed in the resin and the viscosity of the paste increases due to aggregation to cause a problem in the wiring formation by printing. Such a problem is also pointed out, for example, in Patent Document 3.

In this manner, it is not easy to use a dendritic copper powder as a metal filler of an electrically conductive paste or the like, and the dendritic copper powder is also a cause of poor progress in the improvement in electric conductivity of the paste. Incidentally, it is easier for a dendritic shape to secure the contact points than a granular shape in order to secure electric conductivity, and it is thus possible to secure high electric conductivity as an electrically conductive paste or an electromagnetic wave shield.

Patent Document 1: Japanese Unexamined Patent Application, Publication No. 2005-200734
Patent Document 2: Japanese Unexamined Patent Application, Publication No. 2002-15622
Patent Document 3: Japanese Unexamined Patent Application, Publication No. 2011-58027
Patent Document 4: Japanese Unexamined Patent Application, Publication No. H09-3510

DISCLOSURE OF THE INVENTION

Problems to be Solved by the Invention

The present invention has been proposed in view of the circumstances as described above, and an object thereof is to provide a copper powder capable of being suitably utilized in an application such as an electrically conductive paste or an electromagnetic wave shield while securing excellent electric conductivity by increasing the number of contact points among the copper powders.

Means for Solving the Problems

The present inventors have carried out intensive investigations to solve the problems described above. As a result, it has been found out that a copper powder can be uniformly mixed with, for example, a resin while securing excellent electric conductivity and can be thus suitably used in an application such as an electrically conductive paste as the copper powder has a dendritic shape having a linearly grown main stem and a plurality of branches separated from the main stem, the main stem and branches thereof are constituted as flat plate-shaped copper particles having a cross sectional average thickness in a particular range gather, and the copper powder has an average particle diameter (D50) in a particular range, thereby completing the present invention. In other words, the present invention provides the following.

(1) A first aspect of the present invention is a copper powder having a dendritic shape having a linearly grown main stem and a plurality of branches separated from the main stem, in which the main stem and the branches include flat plate-shaped copper particles having a cross sectional average thickness of more than 1.0 $\mu$m and 5.0 $\mu$m or less and the copper powder has a flat plate shape constituted by one layer or a layered structure formed of a plurality of overlapping layers and an average particle diameter (D50) of from 1.0 $\mu$m to 100 $\mu$m.

(2) A second aspect of the present invention is the copper powder according to the first aspect, in which a ratio obtained by dividing a cross sectional thickness of the flat plate-shaped copper particles by an average particle diameter (D50) of the copper powder is in a range of more than 0.01 and 5.0 or less and a bulk density of the copper powder is in a range of from 0.5 g/cm$^3$ to 5 g/cm$^3$.

(3) A third aspect of the present invention is the copper powder according to the first or second aspect, in which a BET specific surface area value of the copper powder is from 0.2 m$^2$/g to 3.0 m$^2$/g.

(4) A fourth aspect of the present invention is the copper powder according to any one of the first to third aspects, in which a crystallite diameter of the flat plate-shaped copper particles in the Miller index of a (111) plane by X-ray diffraction is in a range of from 800 Å to 3000 Å.

(5) A fifth aspect of the present invention is a metal filler including the copper powder according to any one of the first to fourth aspects at a proportion of 20% by mass or more to the entire metal filler.

(6) A sixth aspect of the present invention is a copper paste including the metal filler according to the fifth aspect mixed with a resin.

(7) A seventh aspect of the present invention is an electrically conductive coating material for electromagnetic wave shielding including the metal filler according to the fifth aspect.

(8) A eighth aspect of the present invention is an electrically conductive sheet for electromagnetic wave shielding including the metal filler according to the fifth aspect.

Effects of the Invention

According to the copper powder of the present invention, it is possible to have a large contact area as well as to secure a large number of contact points, to secure excellent electric conductivity, and to prevent aggregation, and the copper powder can be thus suitably utilized in an application such as an electrically conductive paste or an electromagnetic wave shield.

BRIEF DESCRIPTION OF THE DRAWINGS

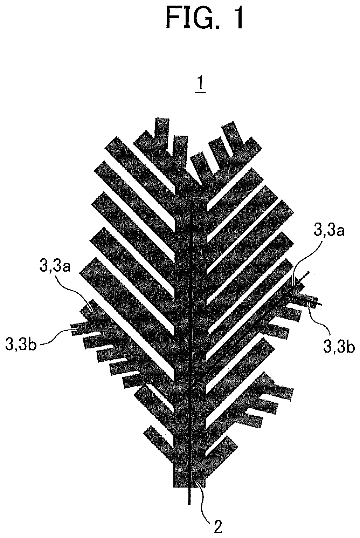

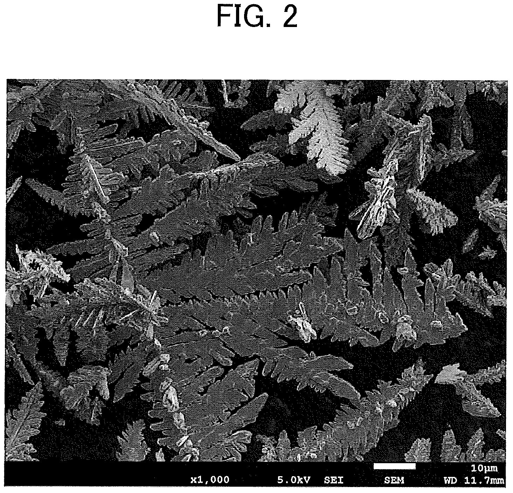

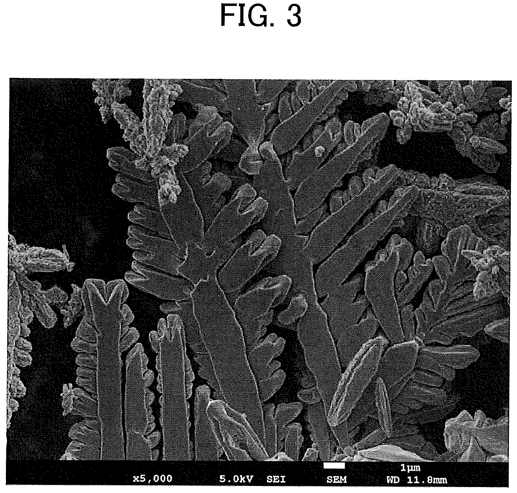

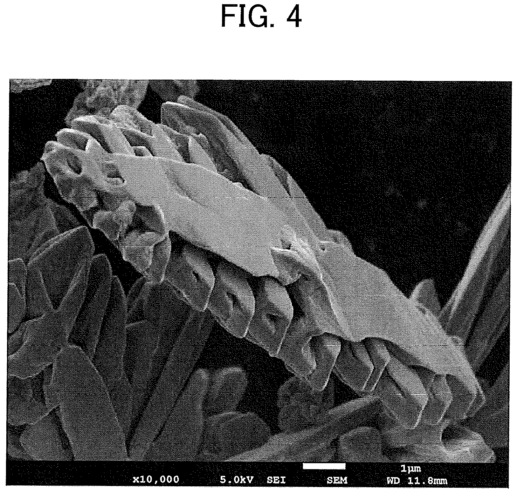

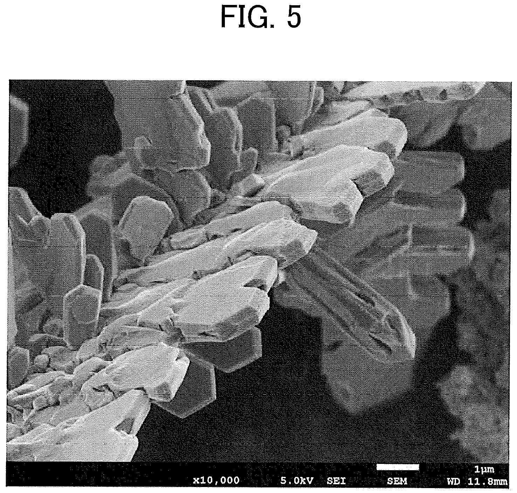

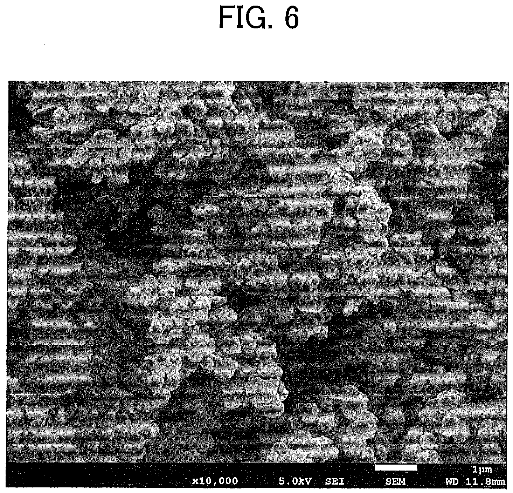

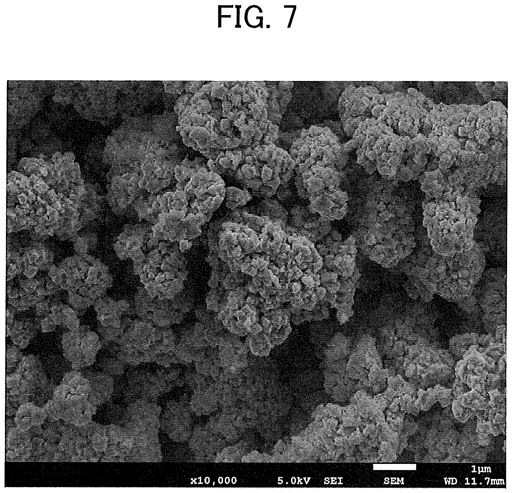

Fig. 1 is a diagram which schematically illustrates a specific shape of copper particles constituting a dendritic copper powder. Fig. 2 is a photograph which illustrates an observation image when a dendritic copper powder is observed through a scanning electron microscope at 1,000-times magnification. Fig. 3 is a photograph which illustrates an observation image when a dendritic copper powder is observed through a scanning electron microscope at 5,000-times magnification. Fig. 4 is a photograph which illustrates an observation image when a dendritic copper powder is observed through a scanning electron microscope at 10,000-times magnification. Fig. 5 is a photograph which illustrates an observation image when a dendritic copper powder is observed through a scanning electron microscope at 10,000-times magnification. Fig. 6 is a photograph which illustrates an observation image when the copper powder obtained in Comparative Example 1 is observed through a scanning electron microscope at 10,000-times magnification. Fig. 7 is a photograph which illustrates an observation image when the copper powder obtained in Comparative Example 2 is observed through a scanning electron microscope at 10,000-times magnification.

PREFERRED MODE FOR CARRYING OUT THE INVENTION

Hereinafter, specific embodiments (hereinafter, referred to as the "present embodiment") of the copper powder according to the present invention will be described in detail with reference to the drawings. However, the present invention is not limited to the following embodiments, and various modifications are possible without changing the essence of the present invention. Incidentally, the notation "X to Y" (X and Y are arbitrary numerical values) in the present specification means "X or more and Y or less".

<<1. Dendritic copper powder>>

In the present embodiment, the copper powder has a dendritic shape having a linearly grown main stem and a plurality of branches separated from the main stem, and the main stem and the branches are constituted by flat plate-shaped copper particles having a particular cross sectional average thickness.

Fig. 1 is a schematic diagram which illustrates a specific shape of the copper particles constituting the copper powder according to the present embodiment. As illustrated in this schematic diagram of Fig. 1, copper particles 1 have a dendritic shape in a two-dimensional or three-dimensional form. More specifically, the copper particles 1 have a dendritic shape having a linearly grown main stem 2 and a plurality of branches 3 that are separated from the main stem 2, and the copper particles 1 have a flat plate shape having a cross sectional average thickness of more than 1.0 μm and 5.0 μm or less. Incidentally, the branch 3 in the copper particles 1 means both a branch 3a that is branched from the main stem 2 and a branch 3b that is further branched from the branch 3a.

The copper powder according to the present embodiment is a copper powder that is constituted as such flat plate-shaped copper particles 1 gather and has a dendritic shape having a main stem and a plurality of branches (hereinafter, also referred to as the "dendritic copper powder") (see the SEM image of the copper powder in Fig. 2), the copper powder has a flat plate shape constituted by one layer or a layered structure formed of a plurality of overlapping layers (see the SEM image of the copper powder in Fig. 4 or Fig. 5), and the average particle diameter (D50) of this dendritic copper powder constituted by the copper particles 1 is from 1.0 μm to 100 μm.

Incidentally, this dendritic copper powder according to the present embodiment can be obtained, for example, by immersing an anode and a cathode in an electrolytic solution which exhibits acidity by sulfuric acid and contains a copper ion and allowing a direct current to flow through the electrolytic solution for electrolysis so as to precipitate copper on the cathode although the production method will be described in detail later.

Fig. 2 to Fig. 5 are photographs which illustrate an example of an observation image when the dendritic copper powder according to the present embodiment is observed through a scanning electron microscope (SEM). Incidentally, Fig. 2 illustrates the dendritic copper powder observed at a 1,000-times magnification, Fig. 3 illustrates the dendritic copper powder observed at a 5,000-times magnification, and Fig. 4 and Fig. 5 illustrate the dendritic copper powder observed at 10,000-times magnification.

As illustrated in the observation image of Fig. 2, this dendritic copper powder is in a precipitated form having a two-dimensional or three-dimensional dendritic shape having a main stem and branches branched from the main stem. In addition, as illustrated in the observation image of Fig. 3, the main stem and the branches constituting the dendritic copper powder are constituted as the copper particles 1 having a flat plate shape and a dendritic shape gather (see the schematic diagram of Fig. 1). In addition, as illustrated in the observation images of Fig. 4 and Fig. 5, this dendritic copper powder is constituted by the grown copper particles 1 in a layered structure formed of a plurality of flat plate layers in Fig. 4 and a flat plate single layer in Fig. 5. As can be seen from these SEM observation images, the dendritic copper powder according to the present embodiment has a flat plate shape and is constituted by one layer or a layered structure formed of a plurality of overlapping layers, and the dendritic copper powder has a dendritic shape having a main stem and branches branched from the main stem as a whole.

Here, the flat plate-shaped copper particles 1 which constitute the dendritic copper powder according to the present embodiment and have the main stem 2 and the branches 3 have a cross sectional average thickness of more than 1.0 μm and 5.0 μm or less. In this manner, as the stem and branches of the dendritic copper powder are constituted by flat plate-shaped copper particles 1 having a cross sectional average thickness of 5.0 μm or thinner, it is possible to secure a large contact area between the copper particles 1 and between the dendritic copper powders constituted by the copper particles 1. Moreover, it is possible to realize a low resistance, namely, a high electric conductivity as the contact area increases. This makes it possible for the copper powder to exhibit superior electric conductivity, to maintain electric conductivity, and to be suitably used in an application of an electrically conductive coating material or an electrically conductive paste. In addition, the dendritic copper powder can contribute to thinning of a wiring material and the like as it is constituted by the flat plate-shaped copper particles 1.

Incidentally, the lower limit of the cross sectional average thickness of the flat plate-shaped copper particles 1 is not particularly limited, but it is possible to obtain a dendritic copper powder in which the flat plate-shaped copper particles 1 having a cross sectional average thickness of more than 1.0 μm are gathered by a method in which the dendritic copper powder is precipitated on the cathode from an electrolytic solution which exhibits acidity by sulfuric acid and contains a copper ion to be described later by electrolysis.

In addition, the average particle diameter (D50) of the dendritic copper powder according to the present embodiment is from 1.0 μm to 100 μm. The average particle diameter can be controlled by changing the electrolysis conditions to be described later. In addition, it is possible to further adjust the average particle diameter to a desired size by additionally conducting mechanical grinding by a jet mill, a sample mill, a cyclone mill, a bead mill, or the like if necessary. Incidentally, the average particle diameter (D50) can be measured by, for example, a method for laser diffraction/scattering type particle size distribution measurement.

Here, for example, as pointed out in Patent Document 1, a problem of a dendritic copper powder is that the dendritic copper powders are intertwined with one another to cause aggregation and are not uniformly dispersed in the resin in some cases when the metal filler in the resin has a developed dendritic shape in the case of utilizing the dendritic copper powder as a metal filler of an electrically conductive paste, a resin for electromagnetic wave shielding, or the like. In addition, the viscosity of the paste increases due to the aggregation so as to cause a problem in wiring formation by printing. This is because the dendritic copper powder radially grows in a needle shape so that the dendritic copper powders are intertwined with one another and aggregate into a large lump.

In this regard, it is possible to prevent the aggregation of copper powders by intertwinement therebetween as the dendritic copper powder according to the present embodiment is constituted by flat plate-shaped copper particles having a cross sectional average thickness of more than 1.0 μm and 5.0 μm or less. In other words, the copper powders come into contact with one another in a plane by growing flat plate-shaped copper particles, and it is thus possible to prevent the aggregation of copper powders by intertwinement therebetween and to uniformly disperse the copper powders in the resin. In addition, by growing the copper particles in a flat plate shape to bring the copper powders into contact with one another in a plane as described above, it is also possible to suppress the contact resistance by contact due to a large area to a low level.

In addition, as described in Patent Document 1 and Patent Document 2, for example, in a case in which a spherical copper powder is formed into a flat plate shape by a mechanical method, the spherical copper powder is processed into a flat plate shape by adding a fatty acid and grinding the spherical copper powder in the air or an inert atmosphere since it is required to prevent the oxidation of copper at the time of mechanical processing. However, it is required to remove the fatty acid after completion of the processing since it is impossible to completely prevent oxidation and the fatty acid added at the time of processing affects the dispersibility when the copper powder is formed into a paste in some cases, but the fatty acid is firmly attached to the copper surface by the pressure at the time of mechanical processing in some cases and a problem arises that the fatty acid cannot be completely removed. Moreover, in the case of using the copper powder as a metal filler of an electrically conductive paste, a resin for electromagnetic wave shielding, or the like, the electric resistance is great and it is impossible to sufficiently exert the properties of the metal filler when an oxide coating film or a fatty acid which inhibits the electric conductivity is present on the surface of the metal filler.

In this regard, the dendritic copper powder according to the present embodiment is fabricated by directly growing the copper powder into the shape of dendritic copper powder without conducting mechanical processing, and thus a problem caused by a residual oxide film or fatty acid which has been a problem so far does not arise, a copper powder having a favorable surface state is formed, and the electrical conductivity can be in a significantly favorable state. Incidentally, the method for producing the copper powder will be described later.

In addition, the dendritic copper powder according to the present embodiment is not particularly limited, but it is preferable that the ratio (cross sectional average thickness/average particle diameter) obtained by dividing the cross sectional average thickness of the flat plate-shaped copper particles 1 by the average particle diameter (D50) of the dendritic copper powder is in a range of more than 0.01 and 5.0 or less.

The ratio (aspect ratio) represented by "cross sectional average thickness/average particle diameter" is an indicator, for example, of the aggregation degree and dispersibility when the dendritic copper powder is processed as an electrically conductive copper paste and the retainability of the appearance shape at the time of applying the copper paste. When this aspect ratio is 0.01 or less, the aggregation of dendritic copper powders is likely to occur and it is difficult to uniformly disperse the dendritic copper powder in the resin at the time of being formed into a paste. On the other hand, when the aspect ratio exceeds 5.0, the dendritic copper powder is close to a copper powder composed of spherical copper particles, and it is thus impossible to sufficiently exert the effect of being a flat plate shape.

In addition, the bulk density of the dendritic copper powder is not particularly limited, but it is preferably in a range of from 0.5 g/cm$^3$ to 5.0 g/cm$^3$. There is a possibility that the contact points among the copper powders cannot be sufficiently secured when the bulk density is less than 0.5 g/cm$^3$. On the other hand, when the bulk density exceeds 5.0 g/cm$^3$, the average particle diameter of the dendritic copper powder also increases, the surface area decreases, and the moldability and the sinterability thus deteriorate in some cases.

In addition, the value of the BET specific surface area of the dendritic copper powder is preferably from 0.2 m$^2$/g to 3.0 m$^2$/g although it is not particularly limited. When the BET specific surface area value is less than 0.2 m$^2$/g, the copper particles 1 constituting the dendritic copper powder do not have the desired flat plate shape as described above and a high electric conductivity is not obtained in some cases. On the other hand, when the BET specific surface area value exceeds 3.0 m$^2$/g, the aggregation of dendritic copper powders is likely to occur and it is difficult to uniformly disperse the dendritic copper powder in the resin at the time of being formed into a paste. Incidentally, the BET specific surface area can be measured in conformity to JIS Z 8830: 2013.

In addition, the dendritic copper powder is not particularly limited, but it is preferable that the crystallite diameter thereof is in a range of from 800 Å (angstrom) to 3,000 Å. When the crystallite diameter is less than 800 Å, the copper particles 1 constituting the main stem and branch tend to have a spherical shape rather than a flat plate shape, it is difficult to secure a sufficiently large contact area, and there is a possibility that electric conductivity decreases. On the other hand, when the crystallite diameter exceeds 3,000 Å, the moldability and sinterability thus deteriorate in some cases.

Incidentally, the crystallite diameter is determined from the diffraction pattern obtained by using an X-ray diffraction measuring apparatus on the basis of the Scherrer equation expressed by the following Equation, and it is a crystallite diameter in Miller index of the (111) plane by X-ray diffraction.

$$D=0.9\lambda/\beta\cos\theta$$

(Incidentally, D: crystallite diameter (Å), $\beta$: diffraction peak spread (rad) depending on crystallite size, $\lambda$: wavelength of X-ray [CuK$\alpha$] (Å), and $\theta$: diffraction angle (°).)

Incidentally, it is possible to obtain the same effect as the copper powder composed only of the dendritic copper powder when the dendritic copper powder having the shape as described above accounts for a predetermined proportion in the obtained copper powder when observed through an electron microscope although copper powders having shapes other than the shape are mixed therein. Specifically, copper powders having shapes other than the shape described above may be contained in the obtained copper powder as long as the dendritic copper powder having the shape described above accounts for 80% by number or more, and preferably 90% by number or more in the entire copper powders when observed through an electron microscope (for example, 500-times to 20,000-times).

<<2. Production method for dendritic copper powder>>

The dendritic copper powder according to the present embodiment can be produced by a predetermined electrolytic method using, for example, a solution which exhibits acidity by sulfuric acid and contains a copper ion as an electrolytic solution.

Upon electrolysis, for example, the solution which exhibits acidity by sulfuric acid and contains a copper ion described above is accommodated in an electrolytic cell in which metallic copper is installed as the anode and a stainless steel plate, a titanium plate, or the like is installed as the cathode and an electrolytic treatment is conducted by applying a direct current to the electrolytic solution at a predetermined current density. This makes it possible to precipitate (electrodeposit) the dendritic copper powder on the cathode along with energization. Particularly, in the present embodiment, it is possible to precipitate the dendritic copper powder in which the flat plate-shaped fine copper particles gather to form a dendritic shape on the surface of the cathode by only the electrolysis without subjecting the copper powder which is obtained by electrolysis and has a granular shape or the like to mechanical deformation processing or the like using a medium such as a ball.

More specifically, as the electrolytic solution, for example, one that contains a water-soluble copper salt, sulfuric acid, an additive such as an amine compound, and a chloride ion can be used.

The water-soluble copper salt is a copper ion source for supplying a copper ion, and examples thereof may include copper sulfate such as copper sulfate pentahydrate, copper chloride, and copper nitrate, but the water-soluble copper salt is not limited thereto. In addition, the concentration of the copper ion in the electrolytic solution can be set to about from 1 g/L to 20 g/L and preferably about from 2 g/L to 10 g/L.

Sulfuric acid is an acid that is used to prepare an electrolytic solution exhibiting acidity from sulfuric acid. The concentration of sulfuric acid in the electrolytic solution may be set to about from 20 g/L to 300 g/L and preferably about from 50 g/L to 200 g/L as the concentration of free sulfuric acid. This concentration of sulfuric acid affects the electric conductivity of the electrolytic solution and it thus affects the uniformity of the copper powder obtained on the cathode.

As an additive, for example, an amine compound can be used. This amine compound contributes to the shape control of the copper powder to be precipitated together with the chloride ion to be described later, and it is thus possible to form the copper powder to be precipitated on the surface of the cathode into a dendritic copper powder having a main stem and a plurality of branches which are constituted by flat plate-shaped copper particles having a dendritic shape and a predetermined cross sectional average thickness.

As the amine compound, for example, Safranin O (3,7-diamino-2,8-dimethyl-5-phenyl-5-phenazinium chloride, $C_{20}H_{19}N_4Cl$, CAS No. 477-73-64) and the like can be used. Incidentally, as the amine compound, one kind may be added singly or two or more kinds may be added concurrently. In addition, the amount of the amine compound added is set to an amount so that the concentration of the amine compound in the electrolytic solution is preferably in a range of more than 50 mg/L and 500 mg/L or less and more preferably in a range of from 100 mg/L to 400 mg/L.

The chloride ion can be contained in the electrolytic solution by adding a compound (chloride ion source) for supplying a chloride ion such as hydrochloric acid and sodium chloride thereto. The chloride ion contributes to the shape control of the copper powder to be precipitated together with the additive such as the amine compound described above. The concentration of the chloride ion in the electrolytic solution is not particularly limited, but the concentration can be set to about from 1 mg/L to 1000 mg/L, and preferably about from 10 mg/L to 500 mg/L.

In the method for producing the dendritic copper powder according to the present embodiment, for example, the dendritic copper powder is produced by precipitating and generating a copper powder on the cathode through electrolysis using the electrolytic solution having the composition as described above. A known method can be used as the electrolysis method. For example, the current density is preferably set to a range of from 5 A/dm$^2$ to 30 A/dm$^2$ upon electrolysis using an electrolytic solution exhibiting acidity by sulfuric acid, and the electrolytic solution is energized while being stirred. In addition, the liquid temperature (bath temperature) of the electrolytic solution can be set, for example, to about from 20°C to 60°C.

<<3. Application such as electrically conductive paste and electrically conductive coating material>>

As described above, the dendritic copper powder according to the present embodiment is a dendritic copper powder having a main stem and a plurality of branches, and this dendritic copper powder is constituted as the copper particles 1 having a dendritic shape having the main stem 2 and a plurality of branches 3 branched from the main stem 2 as illustrated in the schematic diagram of Fig. 1 and a flat plate shape having a cross sectional average thickness of more than 1.0 $\mu$m and 5.0 $\mu$m or less gather. Moreover, the average particle diameter (D50) of the dendritic copper powder is from 1.0 $\mu$m to 100 $\mu$m. Such a dendritic copper powder has a large surface area and exhibits excellent moldability and sinterability by being in a dendritic shape. In addition, the dendritic copper powder can secure a large number of contact points and exerts excellent electric conductivity as the dendritic copper powder is constituted by the flat plate-shaped copper particles 1 having a dendritic shape and a predetermined cross sectional average thickness.

In addition, according to the dendritic copper powder having such a predetermined structure, it is possible to suppress aggregation of the dendritic copper powder and to uniformly disperse the dendritic copper powder in the resin even in the case of forming the dendritic copper powder into a copper paste or the like, and it is also possible to suppress occurrence of defective printing and the like due to an increase in viscosity of the paste or the like. Hence, the dendritic copper powder can be suitably used in applications such as an electrically conductive paste and an electrically conductive coating material.

In the present embodiment, the metal filler is constituted so as to contain the dendritic copper powder described above at a proportion to be an amount of 20% by mass or more, preferably 30% by mass or more, and more preferably 50% by mass or more. When the proportion of the dendritic copper powder in the metal filler is set to 20% by mass or more, it is possible to uniformly disperse the metal filler in the resin and to prevent the occurrence of defective printing due to an excessive increase in viscosity of the paste, for example, in the case of using the metal filler in a copper paste. In addition, it is possible to exert excellent electric conductivity as an electrically conductive paste by being a dendritic copper powder composed of an aggregate of the flat plate-shaped fine copper particles 1. Incidentally, as a metal filler, for example, a spherical copper powder of about from 1 $\mu$m to 20 $\mu$m may be mixed in the metal filler as the rest as long as the dendritic copper powder is contained therein at a proportion to be an amount of 20% by mass or more as described above.

For example, as an electrically conductive paste (copper paste), the electrically conductive paste includes the dendritic copper powder according to the present embodiment as a metal filler and can be fabricated by kneading the dendritic copper powder with a binder resin, a solvent, and further an additive such as an antioxidant or a coupling agent if necessary.

Specifically, the binder resin is not particularly limited, but an epoxy resin, a phenol resin, or the like can be used. In addition, organic solvents such as ethylene glycol, diethylene glycol, triethylene glycol, glycerin, and terpineol can be used as the solvent. In addition, the amount of the organic solvent added is not particularly limited, but the added amount can be adjusted in consideration of the particle size of the dendritic copper powder so as to obtain a viscosity suitable for an electrically conductive film forming method such as screen printing or a dispenser.

Furthermore, it is also possible to add another resin component for adjustment of viscosity. Examples thereof may include a cellulose-based resin typified by ethyl cellulose, and it is added as an organic vehicle prepared by dissolving the resin component in an organic solvent such as terpineol. Incidentally, the amount of the resin component added is required to be suppressed to an extent to which the sinterability is not inhibited, and it is preferably set to 5% by mass or less with respect to the total amount.

In addition, an antioxidant or the like can be added as an additive for improving electric conductivity after calcination. The antioxidant is not particularly limited, but examples thereof may include a hydroxycarboxylic acid. More specifically, a hydroxycarboxylic acid such as citric acid, malic acid, tartaric acid, or lactic acid is preferable, and citric acid or malic acid having a high adsorptive power to copper is even more preferable. The amount of the antioxidant added can be set, for example, to about from 1 to 15% by mass in consideration of the antioxidation effect, the viscosity of the paste, and the like.

Next, the metal filler according to the present embodiment is not limited to utilization under particularly limited conditions in the case of being used as the material for electromagnetic wave shielding as well, and it is possible to use the metal filler by a general method, for example, by mixing it with a resin.

For example, the resin to be used for forming the electromagnetic wave shielding layer of an electrically conductive sheet for electromagnetic wave shielding is not particularly limited, and it is possible to appropriately use a thermoplastic resin, a thermosetting resin, a radiation-curing resin, and the like that are composed of various kinds of polymers and copolymers such as a vinyl chloride resin, a vinyl acetate resin, a vinylidene chloride resin, an acrylic resin, a polyurethane resin, a polyester resin, an olefin resin, a chlorinated olefin resin, a polyvinyl alcohol-based resin, an alkyd resin, and a phenol resin which have been conventionally used.

The method for producing the electromagnetic wave shielding material is not particularly limited, but for example, the electromagnetic wave shielding material can be produced by applying or printing a coating material in which the metal filler and resin as described above are dispersed or dissolved in a solvent on a substrate to form an electromagnetic wave shielding layer and drying the coating material to an extent to which the surface is solidified. In addition, it is possible to utilize the metal filler according to the present embodiment in the electrically conductive adhesive layer of an electrically conductive sheet.

In addition, the metal filler according to the present embodiment is not limited to the use under particularly limited conditions even in the case of forming an electrically conductive coating material for electromagnetic wave shielding by utilizing the metal filler, and it is possible to utilize the metal filler as an electrically conductive coating material by a general method, for example, by mixing it with a resin and a solvent and further with an antioxidant, a thickener, an anti-settling agent, and the like if necessary and kneading the mixture.

The binder resin and solvent to be used at this time are not particularly limited, and a vinyl chloride resin, a vinyl acetate resin, an acrylic resin, a polyester resin, a fluorocarbon resin, a silicone resin, a phenol resin, and the like which have been used in the prior art can be used. In addition, with regard to the solvent as well, it is possible to use an alcohol such as isopropanol, an aromatic hydrocarbon such as toluene, an ester such as methyl acetate, a ketone such as methyl ethyl ketone, and the like which have been used in the prior art. In addition, with regard to the antioxidant as an additive as well, it is possible to use a fatty acid amide, a higher fatty acid amine, a phenylenediamine derivative, a titanate-based coupling agent, and the like which have been used in the prior art.

EXAMPLES

Hereinafter, the present invention will be described more specifically with reference to Examples together with Comparative Examples, but the present invention is not limited to the following Examples at all.

<Evaluation method>

The copper powders obtained in the following Examples and Comparative Examples are subjected to the observation of shape, the measurement of average particle diameter, and the measurement of crystallite diameter by the following methods.

(Observation of shape)

20 arbitrary fields of vision were observed in a field of vision at predetermined magnification through a scanning electron microscope (model: JSM-7100F manufactured by JEOL Ltd.), and the copper powder contained in the field of vision was observed.

(Measurement of average particle diameter)

The average particle diameter (D50) of the obtained copper powder was measured by using a laser diffraction/scattering method particle size distribution measuring instrument (HRA9320 X-100 manufactured by NIKKISO CO., LTD.).

(Measurement of crystallite diameter)

The crystallite diameter was calculated from the diffraction pattern obtained with an X-ray diffraction measuring apparatus (X'Pert PRO manufactured by PAN analytical B. V.) by a method generally known as the Scherrer equation.

(Measurement of aspect ratio)

The obtained copper powder was embedded in an epoxy resin to fabricate a sample for measurement, and the sample was cut and polished, and observed through a scanning electron microscope to observe the cross section of the copper powder. Specifically, first, 20 copper powders were observed and the average thickness (cross sectional average thickness) of the copper powders was determined. Next, the aspect ratio (average thickness/D50) was determined from the ratio of the cross sectional average thickness value to the average particle diameter (D50) determined by using a laser diffraction/scattering method particle size distribution measuring instrument.

(BET specific surface area)

The BET specific surface area was measured by using a specific surface area and pore distribution measuring instrument (QUADRASORB SI manufactured by Quantachrome Instruments).

(Measurement of specific resistance value)

The specific resistance value of the coating film was determined by measuring the sheet resistance value with a four-terminal method using a low resistivity meter (Loresta-GP MCP-T600 manufactured by Mitsubishi Chemical Corporation) and the film thickness of the coating film using a surface roughness and shape measuring instrument (SURFCO M130A manufactured by TOKYO SEIMITSU CO., LTD.) and dividing the sheet resistance value by the film thickness

(Electromagnetic wave shielding property)

The evaluation of the electromagnetic wave shielding property was carried out by measuring the attenuation factor of the samples obtained in the respective Examples and Comparative Examples by using an electromagnetic wave having a frequency of 1 GHz. Specifically, the level in the case of Comparative Example 4 in which the dendritic copper powder was not used was evaluated as "$\triangle$", a case in which the attenuation factor was worse than the level of Comparative Example 4 was evaluated as "$\times$", a case in which the attenuation factor was more favorable than the level of Comparative Example 4 was evaluated as "$\bigcirc$", and a case in which the attenuation factor was superior to the level of Comparative Example 4 was evaluated as "$\odot$".
In addition, it was confirmed whether the electromagnetic wave shielding property changed or not by bending the fabricated electromagnetic wave shield in order to evaluate the flexibility of the electromagnetic wave shield.

<Examples and Comparative Examples>

[Example 1]

A titanium electrode plate having an electrode area of 200 mm $\times$ 200 mm and a copper electrode plate having an electrode area of 200 mm $\times$ 200 mm were installed in an electrolytic cell having a capacity of 100 L as the cathode and the anode, respectively, an electrolytic solution was put in the electrolytic cell, and a direct current was applied to this, thereby precipitating a copper powder on the cathode plate.
At this time, a solution having a composition in which the concentration of copper ion was 5 g/L and the concentration of sulfuric acid was 150 g/L was used as the electrolytic solution. In addition, Safranin O (manufactured by Kanto Chemical Industry Co., Ltd.) as an additive was added to this electrolytic solution so as to have a concentration of 100 mg/L in the electrolytic solution, and a hydrochloric acid solution (manufactured by Wako Pure Chemical Industries, Ltd.) was further added thereto so that the concentration of chloride ion (chlorine ion) in the electrolytic solution was 10 mg/L. Thereafter, the temperature of the electrolytic solution adjusted to the concentration described above was maintained at 25°C while circulating the electrolytic solution with a metering pump at a flow rate of 15 L/min, and an electric current was applied thereto so that the current density of the cathode was 25 A/dm$^2$, thereby precipitating a copper powder on the cathode plate. The electrolytic copper powder precipitated on the cathode plate was mechanically scraped off to the cell bottom of the electrolytic cell by using a scraper and recovered, and the copper powder thus recovered was washed with pure water, then placed in a vacuum dryer, and dried.
The shape of the electrolytic copper powder thus obtained was observed by the method using a scanning electron microscope (SEM) described above, and as a result, at least 90% by number or more of copper powders in the copper powders thus precipitated was a copper powder having a two-dimensional or three-dimensional dendritic shape and a dendritic copper powder formed as copper particles having a dendritic shape having a main stem, a plurality of branches branched from the main stem, and branches further branched from the branches gathered. In addition, the copper powder had a flat plate shape constituted by one layer or a layered structure formed of a plurality of overlapping layers.
In addition, the dendritic copper particles having a main stem and branches had a flat plate shape having a cross sectional average thickness of 3.4 $\mu$m. In addition, the average particle diameter (D50) of the dendritic copper powder was 58.6 $\mu$m. Moreover, the aspect ratio (cross sectional average thickness/average particle diameter) calculated from the cross sectional average thickness of the copper particles and the average particle diameter of the dendritic copper powder was 0.06. In addition, the bulk density of the dendritic copper powder thus obtained was 2.9 g/cm$^3$. In addition, the crystallite diameter of the dendritic copper powder was 2538 Å. In addition, the BET specific surface area was 1.1 m$^2$/g.

[Example 2]

A solution having a composition in which the concentration of copper ion was 7 g/L and the concentration of sulfuric acid was 150 g/L was used as the electrolytic solution, Safranin O as an additive was added to the electrolytic solution so as to have a concentration of 150 mg/L in the electrolytic solution, and a hydrochloric acid solution was further added thereto so that the concentration of chlorine ion in the electrolytic solution was 25 mg/L. Thereafter, the temperature of the electrolytic solution adjusted to the concentration described above was maintained at 30°C while circulating the electrolytic solution at a flow rate of 20 L/min by using a metering pump, and an electric current was applied thereto so that the current density of the cathode was 20 A/dm$^2$, thereby precipitating a copper powder on the cathode plate. An electrolytic copper powder was fabricated under the same conditions as in Example 1 except these conditions.
The shape of the electrolytic copper powder thus obtained was observed by the method using a scanning electron microscope (SEM) described above, and as a result, at least 90% by number or more of copper powders in the copper powders thus precipitated was a copper powder having a two-dimensional or three-dimensional dendritic shape and a dendritic copper powder formed as copper particles having a dendritic shape having a plurality of branches branched from a main stem, and branches further branched from the branches gathered. In addition, the copper powder had a flat plate shape constituted by one layer or a layered structure formed of a plurality of overlapping layers.
In addition, the dendritic copper particles having a main stem and branches had a flat plate shape having a cross sectional average thickness of 1.2 μm. In addition, the average particle diameter (D50) of the dendritic copper powder was 44.3 μm. Moreover, the aspect ratio (cross sectional average thickness/average particle diameter) calculated from the cross sectional average thickness of the copper particles and the average particle diameter of the dendritic copper powder was 0.03. In addition, the bulk density of the dendritic copper powder thus obtained was 1.5 g/cm$^3$. In addition, the crystallite diameter of the dendritic copper powder was 1861 Å. In addition, the BET specific surface area was 1.7 m$^2$/g.

[Example 3]

A solution having a composition in which the concentration of copper ion was 5 g/L and the concentration of sulfuric acid was 125 g/L was used as the electrolytic solution, Safranin O as an additive was added to the electrolytic solution so as to have a concentration of 200 mg/L in the electrolytic solution, and a hydrochloric acid solution was further added thereto so that the concentration of chlorine ion in the electrolytic solution was 25 mg/L. Thereafter, the temperature of the electrolytic solution adjusted to the concentration described above was maintained at 35°C while circulating the electrolytic solution at a flow rate of 25 L/min by using a metering pump, and an electric current was applied thereto so that the current density of the cathode was 25 A/dm$^2$, thereby precipitating a copper powder on the cathode plate. An electrolytic copper powder was fabricated under the same conditions as in Example 1 except these conditions.
The shape of the electrolytic copper powder thus obtained was observed by the method using a scanning electron microscope (SEM) described above, and as a result, at least 90% by number or more of copper powders in the copper powders thus precipitated was a copper powder having a two-dimensional or three-dimensional dendritic shape and a dendritic copper powder formed as copper particles having a dendritic shape having a plurality of branches linearly branched from a main stem and branches further branched from the branches gathered. In addition, the copper powder had a flat plate shape constituted by one layer or a layered structure formed of a plurality of overlapping layers.
In addition, the dendritic copper particles having a main stem and branches had a flat plate shape having a cross sectional average thickness of 2.6 μm. In addition, the average particle diameter (D50) of the dendritic copper powder was 37.4 μm. Moreover, the aspect ratio (cross sectional average thickness/average particle diameter) calculated from the cross sectional average thickness of the copper particles and the average particle diameter of the dendritic copper powder was 0.07. In addition, the bulk density of the dendritic copper powder thus obtained was 1.4 g/cm$^3$. In addition, the crystallite diameter of the dendritic copper powder was 1630 Å. In addition, the BET specific surface area was 1.6 m$^2$/g.

[Example 4]

With 60 parts by mass of the dendritic copper powder obtained in Example 1, 20 parts by mass of a phenol resin (PL-2211 manufactured by Gunei Chemical Industry Co., Ltd.) and 10 parts by mass of butyl cellosolve (KANTO CHEMICAL CO., INC. Cica Special Grade) were mixed, and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. The electrically conductive paste thus obtained was printed on glass by using a metal squeegee and cured for 30 minutes at temperatures of 150°C and 200°C in the air atmosphere.
The specific resistance value of the coating film obtained by curing was 9.4 × 10$^{-5}$ Ω·cm (curing temperature: 150°C) and 2.5 × 10$^{-5}$ Ω·cm (curing temperature: 200°C), respectively.

[Example 5]

With 60 parts by mass of the dendritic copper powder obtained in Example 2, 20 parts by mass of a phenol resin (PL-2211 manufactured by Gunei Chemical Industry Co., Ltd.) and 10 parts by mass of butyl cellosolve (KANTO CHEMICAL CO., INC. Cica Special Grade) were mixed, and the mixture was repeatedly kneaded by using a small kneader (Non-bubbling Kneader NBK-1 manufactured by NIHONSEIKI KAISHA LTD.) for 3 minutes at 1500 rpm four times to be formed into a paste. The electrically conductive paste thus obtained was printed on glass by using a metal squeegee and cured for 30 minutes at temperatures of 150°C and 200°C in the air atmosphere.

The specific resistance value of the coating film obtained by curing was $9.7 \times 10^{-5}$ $\Omega \cdot$cm (curing temperature: 150°C) and $3.1 \times 10^{-5}$ $\Omega \cdot$cm (curing temperature: 200°C), respectively.

[Example 6]

The dendritic copper powder fabricated in Example 1 was dispersed in a resin to produce an electromagnetic wave shielding material.

In other words, 55 g of the dendritic copper powder obtained in Example 1 was mixed with 100 g of a vinyl chloride resin and 200 g of methyl ethyl ketone, respectively, and the mixture was repeatedly kneaded by using a small kneader for 3 minutes at 1500 rpm four times to be formed into a paste. Upon pasting, the copper powder was uniformly dispersed in the resin without aggregating with one another. This was applied on a substrate formed of a transparent polyethylene terephthalate sheet having a thickness of 100 $\mu$m by using a Mayer bar and dried to form an electromagnetic wave shielding layer having a thickness of 20 $\mu$m.

The electromagnetic wave shielding property was evaluated by measuring the attenuation factor by using an electromagnetic wave having a frequency of 1 GHz. The evaluation results on the property are presented in Table 1.

[Comparative Example 1]

An electrolytic copper powder was fabricated by precipitating a copper powder on the cathode plate under the same conditions as in Example 1 except a condition in which Safranin O as an additive and a chlorine ion were not added to the electrolytic solution.

The shape of the electrolytic copper powder thus obtained was observed by the method using a scanning electron microscope (SEM) described above, and as a result, the granular copper particles were gathered although the copper powder thus obtained had a dendritic shape. Incidentally, Fig. 6 is a SEM observation image (magnification: 10,000-times) of the copper powder obtained in this Comparative Example 1. In addition, it was confirmed that the copper powder thus obtained was a significantly large dendritic copper powder having an average particle diameter (D50) of 40 $\mu$m or more.

[Comparative Example 2]

A solution having a composition in which the concentration of copper ion was 10 g/L and the concentration of sulfuric acid was 150 g/L was used as the electrolytic solution. In addition, Safranin O (manufactured by KANTO CHEMICAL CO., INC.) as an additive was added to this electrolytic solution so as to have a concentration of 50 mg/L in the electrolytic solution, and a hydrochloric acid solution (manufactured by Wako Pure Chemical Industries, Ltd.) was further added thereto so that the concentration of chloride ion (chlorine ion) in the electrolytic solution was 10 mg/L. Thereafter, the temperature of the electrolytic solution adjusted to the concentration described above was maintained at 45°C while circulating it at a flow rate of 15 L/min by using a metering pump, and an electric current was applied thereto so that the current density of the cathode was 20 A/dm$^2$, thereby precipitating a copper powder on the cathode plate. Incidentally, an electrolytic copper powder was fabricated under the same conditions as in Example 1 except these conditions.

The shape of the electrolytic copper powder thus obtained was observed in a field of vision at 10,000-times magnification through a SEM and the results thereof are illustrated in Fig. 7. The copper powder thus precipitated was a copper powder having a dendritic shape in which granular copper particles were two-dimensionally or three-dimensionally gathered. The main stem and branch of the dendritic shape were rounded, and the copper powder did not have a flat plate shape constituted by one layer or a layered structure formed of a plurality of overlapping layers as the copper powders obtained in Examples.

[Comparative Example 3]

In order to compare the dendritic copper powder to a flat plate-shaped copper powder of the prior art, a flat plate-shaped copper powder was fabricated by conducting mechanical flattening. Specifically, for the fabrication of a flat plate-shaped copper powder, 5 g of stearic acid was added to 500 g of a granular atomized copper powder (manufactured by MAKIN METAL POWDERS LTD.) having an average particle diameter of 5.4 $\mu$m, and the mixture was subjected to a flattening treatment by a ball mill. Into the ball mill, 5 kg of 3 mm zirconia beads were put, and the mixture was rotated for 90 minutes at a rotation speed of 500 rpm.

The average particle diameter of the flat plate-shaped copper powder thus fabricated was measured by using a particle size distribution measuring instrument by a laser diffraction/scattering method, and as a result, it was 12.6 $\mu$m, and the flat plate-shaped copper powder was observed through a scanning electron microscope, and as a result, the cross sectional average thickness thereof was 0.5 $\mu$m. Moreover, the aspect ratio (cross sectional average thickness/average particle diameter) calculated from the cross sectional average thickness and the average particle diameter thereof was 0.04.

The flat plate-shaped copper powder thus obtained was formed into a paste in the same manner as in Example 4, that is, 15 parts by mass of a phenol resin (PL-2211 manufactured by Gunei Chemical Industry Co., Ltd.) and 10 parts by mass of butyl cellosolve (KANTO CHEMICAL CO., INC. Cica Special Grade) were mixed with 55 parts by mass of the flat plate-shaped copper powder, and the mixture was repeatedly kneaded by using a small kneader (Non-bubbling Kneader NBK-1 manufactured by NIHONSEIKI KAISHA LTD.) for 3 minutes at 1500 rpm four times. The copper paste thus obtained was printed on glass by using a metal squeegee and cured for 30 minutes at temperatures of 150°C and 200°C in the air atmosphere.

The specific resistance value of the coating film obtained by curing was $5.4 \times 10^{-4}$ $\Omega$·cm (curing temperature: 150°C) and $8.2 \times 10^{-5}$ $\Omega$·cm (curing temperature: 200°C), respectively.

[Comparative Example 4]

The flat plate-shaped copper powder fabricated in Comparative Example 3 was dispersed in a resin to produce an electromagnetic wave shielding material.

In other words, 40 g of the flat plate-shaped copper powder obtained in Comparative Example 2 was mixed with 100 g of a vinyl chloride resin and 200 g of methyl ethyl ketone, respectively, and the mixture was repeatedly kneaded by using a small kneader for 3 minutes at 1500 rpm four times to be formed into a paste. Upon pasting, the copper powder was uniformly dispersed in the resin without aggregating with one another. This was applied on a substrate formed of a transparent polyethylene terephthalate sheet having a thickness of 100 $\mu$m by using a Mayer bar and dried to form an electromagnetic wave shielding layer having a thickness of 25 $\mu$m.

The electromagnetic wave shielding property was evaluated by measuring the attenuation factor by using an electromagnetic wave having a frequency of 1 GHz. The evaluation results on the property are presented in Table 1.

[Table 1]

| | Shape | | | Properties of electrically conductive paste ($\times 10^{-5}\Omega$ cm) | | Properties of electromagnetic wave shield | |
|---|---|---|---|---|---|---|---|
| | Cross sectional average thickness [$\mu$m] | Average particle diameter [$\mu$m] | Aspect ratio [Cross sectional average thickness/average particle diameter] | 150°C | 200°C | Plane | Bending |
| Example 1 | 3.4 | 58.6 | 0.06 | - | - | - | - |
| Example 2 | 1.2 | 44.3 | 0.03 | - | - | - | - |
| Example 3 | 0.8 | 11.8 | 0.07 | - | - | - | - |
| Example 4 | 3.4 | 58.6 | 0.06 | 9.4 | 2.5 | - | - |
| Example 5 | 1.2 | 44.3 | 0.03 | 9.7 | 3.1 | - | - |
| Example 6 | 3.4 | 58.6 | 0.06 | - | - | ◎ | ○ |
| Comparative Example 3 | 0.5 | 12.6 | 0.04 | 54 | 8.2 | - | - |
| Comparative Example 4 | 0.5 | 12.6 | 0.04 | - | - | Δ | × |

EXPLANATION OF REFERENCE NUMERALS

1 Copper particle

2 Stem (of copper particle)

3, 3a, and 3b Branch (of copper particle)

**Claims**

1. A copper powder having a dendritic shape having a linearly grown main stem and a plurality of branches separated from the main stem, wherein
   the main stem and the branches include flat plate-shaped copper particles having a cross sectional average thickness of more than 1.0 μm and 5.0 μm or less, and
   the copper powder has a flat plate shape constituted by one layer or a layered structure formed of a plurality of overlapping layers and an average particle diameter (D50) of from 1.0 μm to 100 μm.

2. The copper powder according to claim 1, wherein
   a ratio obtained by dividing a cross sectional thickness of the flat plate-shaped copper particles by an average particle diameter (D50) of the copper powder is in a range of more than 0.01 and 5.0 or less, and
   a bulk density of the copper powder is in a range of from 0.5 g/cm$^3$ to 5 g/cm$^3$.

3. The copper powder according to claim 1 or 2, wherein a BET specific surface area value of the copper powder is from 0.2 m$^2$/g to 3.0 m$^2$/g.

4. The copper powder according to any one of claims 1 to 3, wherein
   a crystallite diameter of the flat plate-shaped copper particles in the Miller index of a (111) plane by X-ray diffraction is in a range of from 800 Å to 3000 Å.

5. A metal filler comprising the copper powder according to any one of claims 1 to 4 at a proportion of 20% by mass or more to the entire metal filler.

6. A copper paste comprising the metal filler according to claim 5 mixed with a resin.

7. An electrically conductive coating material for electromagnetic wave shielding comprising the metal filler according to claim 5.

8. An electrically conductive sheet for electromagnetic wave shielding comprising the metal filler according to claim 5.

# FIG. 1

# FIG. 2

FIG. 3

FIG. 4

# FIG. 5

FIG. 6

# FIG. 7

## INTERNATIONAL SEARCH REPORT

International application No.

PCT/JP2015/059481

| A. CLASSIFICATION OF SUBJECT MATTER |
|---|
| B22F1/00(2006.01)i, C09C1/62(2006.01)i, C09D5/24(2006.01)i, C09D201/00 (2006.01)i, C25C5/02(2006.01)i, H01B1/00(2006.01)i, H01B1/22(2006.01)i, H01B5/00(2006.01)i |

According to International Patent Classification (IPC) or to both national classification and IPC

| B. FIELDS SEARCHED |
|---|
| Minimum documentation searched (classification system followed by classification symbols) |
| B22F1/00, C09C1/62, C09D5/24, C09D201/00, C25C5/02, H01B1/00, H01B1/22, H01B5/00 |

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)

JSTPlus(JDreamIII)

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2013-053347 A (Mitsui Mining & Smelting Co., Ltd.), 21 March 2013 (21.03.2013), entire text (Family: none) | 1-8 |
| A | JP 2013-100592 A (Mitsui Mining & Smelting Co., Ltd.), 23 May 2013 (23.05.2013), entire text & CN 103056356 A & KR 10-2013-0044132 A & TW 201317311 A | 1-8 |

☒ Further documents are listed in the continuation of Box C.   ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 16 June 2015 (16.06.15) | 23 June 2015 (23.06.15) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (July 2009)

**INTERNATIONAL SEARCH REPORT**

International application No.

PCT/JP2015/059481

C (Continuation).   DOCUMENTS CONSIDERED TO BE RELEVANT

| Category* | Citation of document, with indication, where appropriate, of the relevant passages | Relevant to claim No. |
|---|---|---|
| A | JP 5503813 B1  (Mitsui Mining & Smelting Co., Ltd.), 28 May 2014 (28.05.2014), entire text & WO 2014/021037 A1 | 1-8 |
| A | JP 2011-214032 A  (JX Nippon Mining & Metals Corp.), 27 October 2011 (27.10.2011), paragraph [0014]; fig. 1 (Family: none) | 1-8 |

Form PCT/ISA/210 (continuation of second sheet) (July 2009)

**REFERENCES CITED IN THE DESCRIPTION**

**Patent documents cited in the description**

- JP 2005200734 A
- JP 2002015622 A
- JP 2011058027 A
- JP H093510 B

**Non-patent literature cited in the description**

- *CHEMICAL ABSTRACTS,* 477-73-64